(19) Europäisches Patentamt
European Patent Office
Office européen des brevets

(11) **EP 3 591 722 B1**

(12) **EUROPEAN PATENT SPECIFICATION**

(45) Date of publication and mention
of the grant of the patent:
**03.04.2024   Bulletin 2024/14**

(21) Application number: **18760381.6**

(22) Date of filing: **27.02.2018**

(51) International Patent Classification (IPC):
**G02B 19/00** *(2006.01)*    **G02F 1/13357** *(2006.01)*
**H01L 33/58** *(2010.01)*    *H01L 25/075* *(2006.01)*

(52) Cooperative Patent Classification (CPC):
**H01L 33/58; G02B 19/0066; G02F 1/133603;**
**G02F 1/133606;** G02F 1/133607; H01L 25/0753

(86) International application number:
**PCT/KR2018/002377**

(87) International publication number:
**WO 2018/159977 (07.09.2018 Gazette 2018/36)**

(54) **DISPLAY DEVICE, BACKLIGHT UNIT, LIGHT-EMITTING MODULE AND LENS**

ANZEIGEVORRICHTUNG, HINTERGRUNDBELEUCHTUNGSEINHEIT, LICHTEMITTIERENDES MODUL UND LINSE

DISPOSITIF D'AFFICHAGE, UNITÉ DE RÉTROÉCLAIRAGE, MODULE ÉLECTROLUMINESCENT ET LENTILLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.02.2017   KR 20170026197**
**21.02.2018   KR 20180020302**

(43) Date of publication of application:
**08.01.2020   Bulletin 2020/02**

(73) Proprietor: **Seoul Semiconductor Co., Ltd.**
**Ansan-si, Gyeonggi-do 15429 (KR)**

(72) Inventors:
• **KIM, Eun Ju**
**Ansan-si**
**Gyeonggi-do 15429 (KR)**

• **PARK, Jae Eun**
**Ansan-si**
**Gyeonggi-do 15429 (KR)**

(74) Representative: **Stolmár & Partner**
**Patentanwälte PartG mbB**
**Blumenstraße 17**
**80331 München (DE)**

(56) References cited:
**EP-A1- 3 208 533       EP-A2- 2 317 216**
**JP-A- 2015 090 772     JP-A- 2015 090 772**
**JP-A- 2016 127 030     KR-A- 20130 073 319**
**KR-A- 20130 073 319    KR-B1- 101 146 458**
**KR-B1- 101 690 740     KR-B1- 101 690 740**
**US-A1- 2012 050 889    US-A1- 2012 057 354**
**US-A1- 2015 192 255    US-A1- 2016 201 875**
**US-A1- 2016 356 451**

**Description**

[Technical Field]

The present invention relates to a display device, a backlight unit, a light emitting module, and a lens, and more particularly, to a display device, a backlight unit, a light emitting module, and a lens capable of specifying a light emission distribution emitted to the outside.

[Background Art]

A light emitting diode is an inorganic semiconductor device which emits light generated by recombination of electrons and holes. In recent years, light emitting diodes have been widely used in various fields such as display devices, vehicular lamps, general lighting, and the like. With various advantages such as longer lifespan, lower power consumption, and more rapid response compared to conventional light sources, the light emitting diodes have been rapidly replacing existing light sources in the art.

When using the light emitting diode for a display device or a general lighting, several to tens of light emitting diodes may be used. When using so many light emitting diodes, it is essential to minimize optical interference between light emitting diodes. Otherwise, interference of light emitted from each of the light emitting diodes may occur, resulting in shadows or partial hot spots. Documents KR101690740 B1, US 2016/201875 A1 describe a light emitting module comprising a plurality of light emitting devices mounted on an elongated substrate, each light emitting device being covered by a lens.

[Disclosure of Invention]

[Technical Problem]

The invention is set out in the appending claims. Exemplary embodiments of the present invention provide a display device and a backlight unit. Further disclosed are a light emitting module and a lens capable of minimizing optical interference between each of light emitting diodes when using a plurality of light emitting diodes.

[Technical Solution]

A light emitting module according to an example not forming part of the present invention may include: a light emitting device; and a lens disposed on the light emitting device to spread light emitted from the light emitting device, wherein the lens includes a light entering part on which the light emitted from the light emitting device is incident and a light exiting part through which the incident light is emitted, wherein each of the light entering part and the light exiting part has a shape having a major axis and a minor axis in plan view, the major axis of the light entering part is orthogonal to the major axis of the light exiting part, and the light entering part includes a light incident vertical surface extending from a lower surface of the lens and a light incident inclined surface extending upward from the light incident vertical surface.

In this case, the lens may have a protruding surface protruding from the lower surface of the lens to have a predetermined curvature.

Here, the light entering part may be formed upwardly in a concave shape on the protruding surface of the lens, and an inner surface of the concave shape may include a light incident vertical surface extending from the protruding surface of the lens and a light incident inclined surface extending from the light incident vertical surface.

In addition, the lens may further include a plurality of legs coupled to the lower surface of the lens to support the lens.

In this case, the plurality of legs may be disposed outside of the protruding surface.

The lens may further include a flange connecting the light exiting part and the lower surface of the lens.

Here, a height of the light incident vertical surface may be smaller than a thickness of the flange.

In addition, the thickness of the flange may be greater at a major axis of the light exiting part than at a minor axis of the light exiting part.

A shortest distance from the end of the light exiting part of the lens at the major axis of the light exiting part to the end of the flange at the major axis of the flange may be different from a shortest distance from the end of the light exiting part of the lens at the minor axis of the light exiting part to the end of the flange at the minor axis of the flange.

A lens according to an example not forming part of the present invention may include: a light entering part formed in a concave shape in a lower region of the lens, and on which light emitted from the light emitting device is incident; and a light exiting part through which the light incident through the light entering part is emitted to the outside,

wherein each of the light entering part and the light exiting part has a shape having a major axis and a minor axis in plan view, the major axis of the light entering part is orthogonal to the major axis of the light exiting part, and the light entering part includes a light incident vertical surface extending from the lower surface of the lens and a light incident inclined surface extending upward from the light incident vertical surface.

In this case, the lower surface may further include a protruding surface protruding to have a predetermined curvature to surround the light entering part.

In addition, an inner surface of the light entering part may include a light incident vertical surface extending from the protruding surface and a light incident inclined surface extending from the light incident vertical surface.

Moreover, the lens may further include a plurality of legs coupled to the lower surface, and the plurality of legs may be disposed outside of the protruding surface.

The lens may further include a flange connecting the light exiting part and the lower surface, and a height of the light incident vertical surface may be smaller than a thickness of the flange.

In this case, the thickness of the flange may be greater at a major axis of the light exiting part than at a minor axis of the light exiting part.

A backlight unit according to an embodiment of the present invention includes: at least one backlight module including: a substrate; a plurality of light emitting devices disposed on the substrate; and a plurality of lenses disposed over the plurality of light emitting devices, respectively, to spread light emitted from the light emitting devices, wherein each of the plurality of lenses includes a light entering part on which the light emitted from the light emitting device is incident and a light exiting part through which the incident light is emitted to the outside, wherein each of the light entering part and the light exiting part has a shape having a major axis and a minor axis in plan view, the major axis of the light entering part is orthogonal to the major axis of the light exiting part, and the light entering part includes a light incident vertical surface extending from the lower surface of the lens and a light incident inclined surface extending upward from the light incident vertical surface.

Here, the at least one backlight module may be plural, and the plurality of backlight modules may be disposed at predetermined intervals.

The substrate has a predetermined length, and the plurality of backlight modules may be disposed at a predetermined interval in a direction perpendicular to the longitudinal direction of the substrate.

The substrate has a predetermined length, and the plurality of lenses is arranged so that the major axis of the light exiting part is perpendicular to the longitudinal direction of the substrate.

The substrate has the predetermined length, and a width of the light entering part in the minor axis direction may be smaller than a width of the substrate.

Each of the plurality of lenses may further include a plurality of legs arranged at a longer interval along the light entering part in the major axis direction.

A display device according to an embodiment of the present invention includes: at least one backlight module including: a substrate; a plurality of light emitting devices disposed on the substrate; and a plurality of lenses disposed over the plurality of light emitting devices, respectively, to spread light emitted from the light emitting devices, wherein each of the plurality of lenses includes a light entering part on which the light emitted from the light emitting device is incident and a light exiting part through which the incident light is emitted to the outside, wherein each of the light entering part and the light exiting part has a shape having a major axis and a minor axis in plan view, the major axis of the light entering part is orthogonal to the major axis of the light exiting part, and wherein the light entering part includes a light incident vertical surface extending from the lower surface of the lens and a light incident inclined surface extending upward from the light incident vertical surface.

Here, the substrate has a predetermined length, the at least one backlight module may be plural, and the plurality of one backlight modules may be disposed at a predetermined interval in a direction perpendicular to the longitudinal direction of the substrate.

In addition, the substrate has the predetermined length, and the plurality of lenses is disposed so that the major axis of the light exiting part is perpendicular to the longitudinal direction of the substrate.

The substrate has the predetermined length, and a width of the light entering part in the minor axis direction may be smaller than a width of the substrate.

Each of the plurality of lenses may further include a plurality of legs arranged at a longer interval along the light entering part in the major axis direction.

[Advantageous Effects]

According to the present invention, since a distribution of light emitted from the light emitting module may have a near rectangular shape, there is an effect that uniform light may be emitted to the outside by combination with the distribution of light emitted from adjacent light emitting modules.

[Description of Drawings]

FIG. 1 is a perspective view illustrating a light emitting module according to a first example not forming part of the present invention.

FIG. 2 is a cross-sectional view illustrating a major axis of a lens included in the light emitting module according to the first example.

FIG. 3 is a cross-sectional view illustrating a minor axis of the lens included in the light emitting module according to the first example.

FIG. 4 is a cross-sectional view illustrating a major axis of the light emitting module according to the first example.

FIG. 5 is a cross-sectional view illustrating a minor axis of the light emitting module according to the first example.

FIG. 6 is a view illustrating the light emitting module according to the first example mounted on a substrate.

FIG. 7 is a view illustrating a backlight unit of a 32-inch display device equipped with the light emitting module according to the first example.

FIG. 8 is a view illustrating a backlight unit of a 55-inch display device equipped with the light emitting module according to the first example.

FIG. 9 is a cross-sectional view illustrating a major axis of a lens included in a light emitting module according to a second example not forming part of the present invention.

FIG. 10 is a plan view illustrating the lens included in the light emitting module according to the second example.

FIG. 11 is a graph comparing a brightness of light emitted from the major axis of a light exiting part in the light emitting module according to the second example and a brightness of light emitted from the major axis of a light exiting part in the light emitting module according to the first example.

FIG. 12 is a graph comparing a brightness of light emitted from the minor axis of the light exiting part in the light emitting module according to the second example and a brightness of light emitted from the minor axis of the light exiting part in the light emitting module according to the first example.

FIG. 13 is a perspective view illustrating a light emitting module according to a third example not forming part of the present invention.

FIG. 14 is a side view illustrating a major axis of a light exiting part of a lens included in the light emitting module according to the third example.

FIG. 15 is a side view illustrating a minor axis of the light exiting part of the lens included in the light emitting module according to the third example.

FIG. 16 is a view illustrating the light exiting part of the lens included in the light emitting module according to the third example.

FIG. 17 is a view illustrating light emitted from the light emitting module according to the third example with a side view showing the major axis of the light emitting module.

[Best Mode for Invention]

Preferred examples will be described in detail with reference to the accompanying drawings.

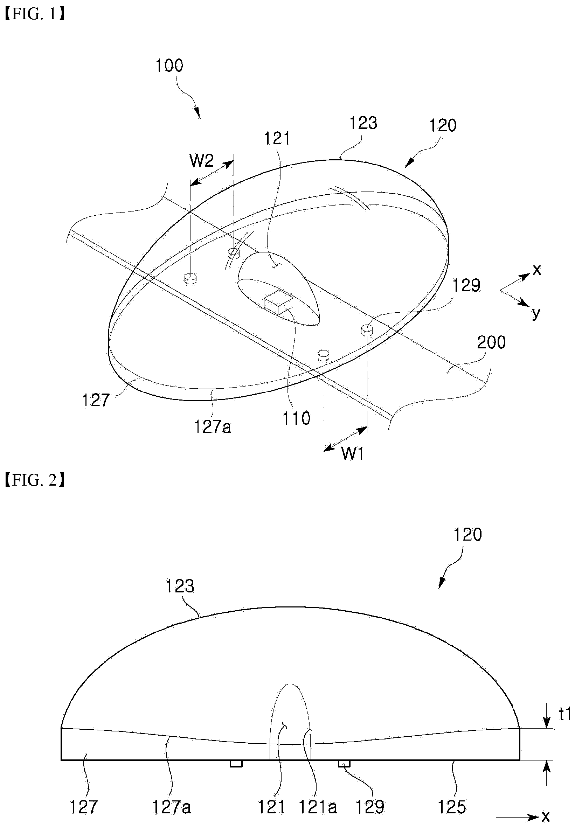

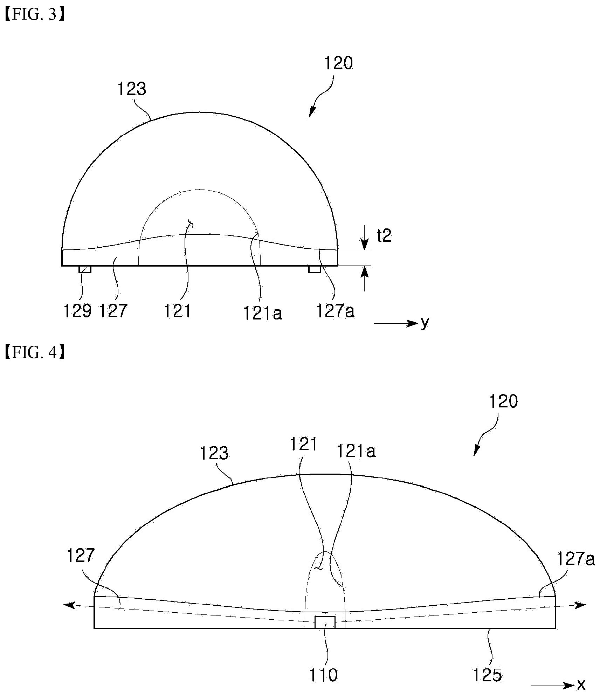

FIG. 1 is a perspective view illustrating a light emitting module according to a first example, and FIG. 2 is a cross-sectional view illustrating a major axis of a lens included in the light emitting module according to the first example. FIG. 3 is a cross-sectional view illustrating a minor axis of the lens included in the light emitting module according to the first example.

Referring to FIG. 1, a light emitting module 100 according to the first example includes a light emitting device 110 and a lens 120.

The light emitting device 110 is disposed on a substrate 200. Here, the substrate 200 has an insulation property, and a conductive circuit may be formed on an upper region thereof. The substrate 200 serves to support the light emitting device 110 and the lens 120. In this embodiment, the substrate 200 may be a printed circuit board, and may have a mounting groove on which the light emitting device 110 is mounted.

The light emitting device 110 may be mounted on the substrate 200 and may be mounted in the mounting groove in a case that the mounting groove is formed on the substrate 200. The light emitting device 110 may be in the form of a package in which a light emitting diode chip is mounted on a housing or a sub-mount, or in the form in which the light emitting diode chip may be directly mounted on the substrate 200.

In a case that the light emitting device 110 is in the form of the light emitting diode chip, the light emitting diode chip may include a light emitting structure including an n-type semiconductor layer, an active layer, and a p-type semiconductor layer. Moreover, it may be a flip chip type in which an n-type electrode electrically connected to the n-type semiconductor layer and a p-type electrode electrically connected to the p-type semiconductor layer are arranged in one side, and may be a vertical type in which the n-type electrode and the p-type electrode are arranged in different sides. Here, each of the n-type semiconductor layer, the active layer, and the p-type semiconductor layer may include a III-V compound semiconductor, for example, a nitride semiconductor such as (Al, Ga, In) N.

The n-type semiconductor layer may be a conductive semiconductor layer containing an n-type impurity (e.g., Si), and the p-type semiconductor layer may be a conductive semiconductor layer containing a p-type impurity (e.g., Mg). The active layer may be interposed between the n-type semiconductor layer and the p-type semiconductor layer, and may include a multiple quantum well structure (MQW). A composition ratio may be determined to emit light having a desired peak wavelength. In this embodiment, the composition ratio of the light emitting diode chip may be determined to emit blue light or ultraviolet light to the outside.

The lens 120 is provided to spread light emitted from the light emitting device 110 and is disposed to cover the light emitting device 110. For this purpose, the lens 120 may have a light incident surface 121a on which light emitted from the light emitting device 110 is incident and a light exiting part 123 through which light is emitted to the outside from the lens 120. In this embodiment, the lens 120 includes a light entering part 121 in a concave shape in a lower region thereof, and an inner surface of the light entering part 121 may be the light incident surface 121a.

The light entering part 121 may be formed in the lower region of the lens 120 and may be disposed at a center of the lens 120 as shown in the drawings. A shape of the light entering part 121 may be the concave shape like a bell shape as shown in FIGs. 1 to 3. In the present embodiment, the minor axis direction of the elliptical light entering part 121 is defined as an x-axis direction, and the major axis direction of light entering part 121 is defined as a y-axis direction.

The light incident surface 121a which is the inner surface of the light entering part 121 may have a curved surface as a whole. The light incident surface 121a and a lower surface 125 of the lens 120 may be connected to each other by the curved surface. In the present embodiment, the light incident surface 121a may have the curved surface as a whole, but an upper most region of the light incident surface 121a may include a flat surface if necessary.

In this example, the lower surface 125 of the lens 120 may have a planar shape, as shown in the drawings. However, the present invention is not limited thereto, but it may include an inclined surface if necessary. In a case that the lower surface 125 includes an inclined surface, the inclined surface may be a surface inclined upward from the light entering part 121 toward an outer surface of the lens 120.

The light exiting part 123 forms an outer shape of the lens 120 with a surface through which the light incident on the lens 120 is emitted to the outside. A horizontal sectional surface of the light exiting part 123 may have an elliptical shape having a major axis in the x-axis direction. In this example, the minor axis direction of the elliptical light exiting part 123 is the y-axis direction, and the major axis direction of the light exiting part 123 is the x-axis direction. That is, the major axis of the light entering part 121 and the major axis of the light exiting part 123 are arranged perpendicular to each other.

Here, the elliptical shape of the light entering part 121 may be larger than that of the light exiting part 123 in a ratio of the major axis to the minor axis. That is, the elliptical shape of the light exiting part 123 may be the elliptic shape closer to a circular shape than that of the light entering part 121. Accordingly, the light emitted from the light emitting device 110 may be relatively more incident toward the major axis of the light exiting part 123.

As a result, in the cross section taken along the x-axis direction of the lens 120 as shown in FIG. 2, the light exiting part 123 is disposed in the major axis direction, and the light entering part 121 is disposed in the minor axis direction. In the cross section taken along the y-axis direction of the lens 120 as shown in FIG. 3, the light exiting part 123 is disposed in the minor axis direction, and the light entering part 121 is disposed in the major axis direction. Thus, it can be seen that the light incident on the lens 120 through the light entering part 121 in the minor axis direction has a relatively longer transmission distance of the lens 120 than the light incident in the major axis direction, for the light incident on the lens 120 through the light entering part 121.

Moreover, the lens 120 may further include a flange 127 connecting the light exiting part 123 and the lower surface 120 of the lens 120. The flange 127 may be disposed along an outer periphery of the light exiting part 123 and a longitudinal side surface of the flange 127 may be perpendicular to the lower surface 125 of the lens 120. In this case, a thickness of the flange 127 may vary depending on a location of a light emitting surface. In this example, a thickness t1 of the flange 127 located at the major axis of the light exiting part 123 may be relatively thicker than a thickness t2 of the flange 127 located at the minor axis of the light exiting part 123. The thickness of the flange 127 may be the thickest at the major axis of the light exiting part 123 and the thinnest at the minor axis of the light exiting part 123. At this time, a boundary 127a which is a boundary between the flange 127 and the light exiting part 123 may be formed as a curved line as shown in FIGs. 1 to 3.

Further, a plurality of legs 129 may be disposed on the lower surface 125 of the lens 120. The leg 129 may be disposed around the light entering part 121 and may have a predetermined thickness, and may be a standard for mounting the lens 120 properly when the lens 120 is coupled to the substrate 200.

The plurality of legs 129 may be disposed at a longer interval along the major axis of the light entering part 121. That is, in this example, four legs 129 are disposed; Two legs 129 may be disposed at a first interval W1 on one side of the light entering part 121 at the major axis, and remaining two legs 129 may be disposed at a second interval W2 on an opposite side to the one side of the light entering part 121 at the major axis. At this time, the first interval W1 and the second interval W2 may be equal to each other. An interval between the two legs 129 disposed on the one side of the light entering part 121 and the two legs 129 disposed on the other side may be longer than the first and second intervals W1 and W2.

FIG. 4 is a cross-sectional view illustrating a major axis of the light emitting module according to the first example.

Referring to FIG. 4, the light emitting device 110 of the light emitting module 100 according to the first example is disposed in the light entering part 121 of the lens 120, as shown in the drawing. In this example, the light emitting device 110 may be a flip chip type light emitting device 110, and accordingly, the light emitting device 110 emits light upwards and sidewards from the light emitting device 110.

Light emitted upwards from the light emitting device 110 may be emitted to the outside through the light exiting part 123 via the light entering part 121 of the lens 120. A portion of the light emitted sidewards from the light emitting device 110 may be emitted to the outside through the light exiting part 123 via the light entering part 121, but the light incident on the light entering part 121 may be emitted to the outside through the flange 127 as shown in the drawing. Accordingly, the light emitted through the flange 127 may be emitted to the outside without being refracted by the lens 120, thereby increasing the amount of light emitted from the side surface of the lens 120.

In this example, it is described that the thickness of the major axis of the flange 127 is different from that of the minor axis of the flange 127. Since the thickness of the major axis of the lens 120 is formed thicker than that of the minor axis of the lens 120, an amount of light emitted to the major axis may be relatively larger than an amount of light emitted to the minor axis of the lens 120. That is, as the thickness of the flange 127 is thicker, the amount of light emitted to the major axis of the lens 120 having the relatively large thickness of the flange 127 may be relatively large since an amount of unrefracted light emitted through the flange 127 after being emitted from the light emitting device 110 is a relatively large.

As a result, the lens 120 according to the present example may spread light more in the major axis direction than in the minor axis direction.

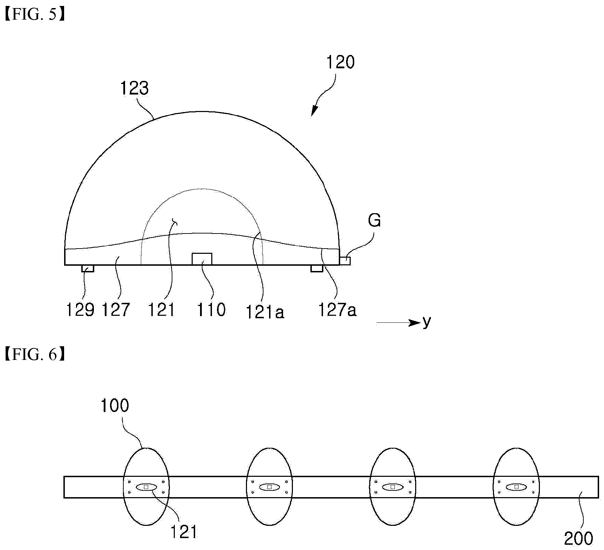

FIG. 5 is a cross-sectional view illustrating a minor axis of the light emitting module according to the first example.

Referring to FIG. 5, the lens 120 of the light emitting module 100 according to the present example may be formed through injection. A shape of a gate G for the injection mold may be formed in the flange 127 of the lens 120. Here, a thickness of the flange 127 at the minor axis may be determined by a thickness of the gate G, and may be thicker than the thickness of the gate G.

In this example, the thickness of the flange 127 may be greater at the major axis than at the minor axis, and may be less than 4 mm. Further, the thickness of the flange 127 at the minor axis may be 0.3 mm to 1 mm.

FIG. 6 is a view illustrating the light emitting module according to the first example mounted on the substrate 200.

Referring to FIG. 6, a plurality of light emitting modules 100 may be disposed on the substrate 200. The substrate 200 may have a bar shape having the longitudinal direction and a conductive circuit may be formed to supply power to the light emitting device 110 mounted on an upper surface of the substrate 200. The light emitting module may be formed by disposing lenses 120 to cover a plurality of light emitting devices 110 in a state where the plurality of light emitting devices 110 are coupled to the conductive circuit of the substrate 200.

As shown in FIG. 6, the lens 120 may be disposed on the substrate 200 with a structure that the major axis direction of the light entering part 121 coincides with the longitudinal direction of the substrate 200. Accordingly, the major axis of the light exiting part 123 of the lens 120 may be arranged perpendicular to the longitudinal direction of the substrate 200 and the lens 120 may be relatively protruding to an outer surface of the substrate 200. Further, a width of the light entering part 121 of the lens 120 in the minor axis direction may be smaller than a width of the substrate 200. The legs 129 of the lens 120 may be coupled to the substrate 200, and thus the lens 120 may be coupled to the substrate 200.

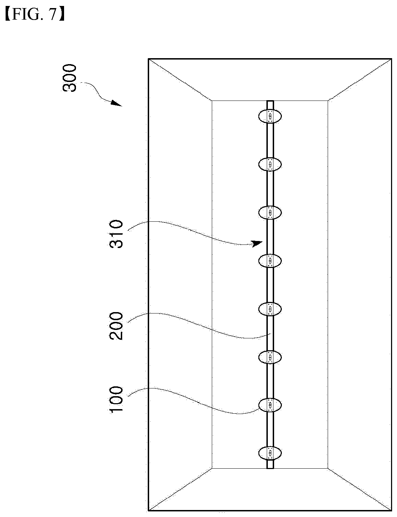

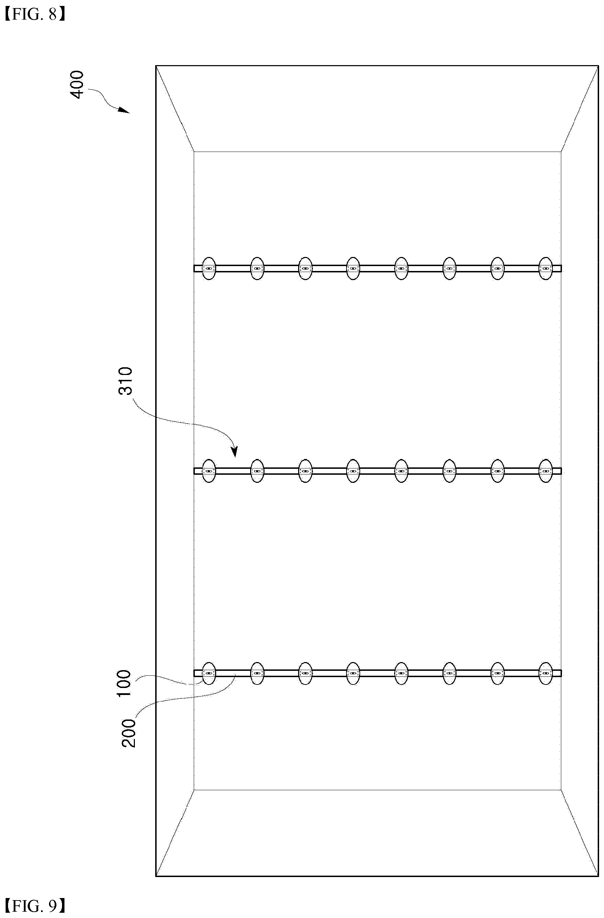

FIG. 7 is a view illustrating a backlight unit of a 32-inch display device equipped with the light emitting module according to the first example, and FIG. 8 is a view illustrating a backlight unit of a 55-inch display device equipped with the light emitting module according to the first example.

Referring to FIG. 7, a backlight unit 300 of the 32-inch display device may include a backlight module 310. The backlight module 310 may include a plurality of light emitting modules 100 arranged at regular intervals on the substrate 200 having a predetermined length.

In this case, one backlight module 310 may be installed in the 32-inch backlight unit 300, and the backlight module 310 may be disposed at a center of the backlight unit 300 in the longitudinal direction of the backlight unit 300. Accordingly, the light emitted from the plurality of light emitting modules 100 may be emitted in a direction perpendicular to the longitudinal direction of the substrate 200 and irradiated onto an entire surface of the backlight unit 300.

Referring to FIG. 8, a backlight unit 400 of the 55-inch display device may have three backlight modules 310 each arranged in a direction perpendicular to the longitudinal direction of the backlight unit. The backlight module 310, as shown in the drawing, includes the substrate 200 having an one-directional length and the plurality of light emitting modules 100 disposed on the substrate 200. Accordingly, the backlight module 310 has the one-directional length as the substrate 200 does. The three backlight modules 310 disposed in the backlight unit 400 of the 55-inch display device may be disposed in a direction perpendicular to the longitudinal direction of the backlight module 310.

Each of the backlight modules 310 includes the plurality of light emitting modules 100 on the single substrate 200. The light emitted from each light emitting module 100 may be emitted with a light distribution characteristic having the direction perpendicular to the longitudinal direction of the substrate 200, and thus the light may be irradiated onto an entire surface of the backlight unit 400.

In this case, the number of the backlight modules 310 disposed and the number of the light emitting modules 100 disposed on the substrate 200 may be different depending on a size of the display device.

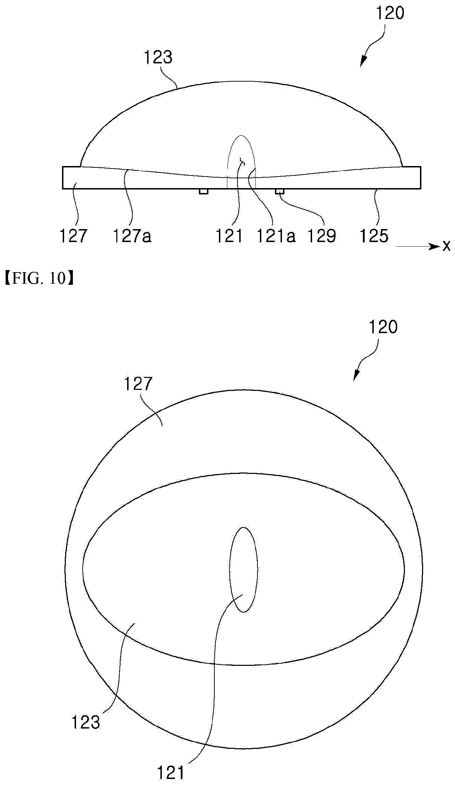

FIG. 9 is a cross-sectional view illustrating a major axis of a lens included in a light emitting module according to a second example, and FIG. 10 is a plan view illustrating the lens included in the light emitting module according to the second example.

Referring to FIGs. 9 and 10, a light emitting module 100 according to a second example includes a light emitting device 110 and a lens 120. In the present example, the configuration of the light emitting device 110 is the same as that in the first embodiment, and a description thereof will be omitted, and a description of the same configuration of the lens 120 will be omitted.

In the present example, the lens 120 includes a light entering part 121, a light exiting part 123, a flange 127, and a leg 129, and the configurations of the light entering part 121, the light exiting part 123, and the leg 129 are the same as those of the first example. In the present example, the flange 127 may protrude to an outer surface of the lens 120 at the light exiting part 123. That is, a width of the flange 127 may be relatively larger than a width of the light exiting part 123 of the lens 120 at the major axis (x-axis direction) as shown in FIG. 9.

Moreover, as shown in FIG. 10, the flange 127 may have a circular shape in plan view. That is, whereas the light exiting part 123 of the lens 120 has the elliptical shape, the flange 127 has the circular shape. Accordingly, a distance from an end of an outer surface of the flange 127 to an end of an outer surface of the light exiting part 123 may be different from each other at the major axis and the minor axis of the light exiting part 123.

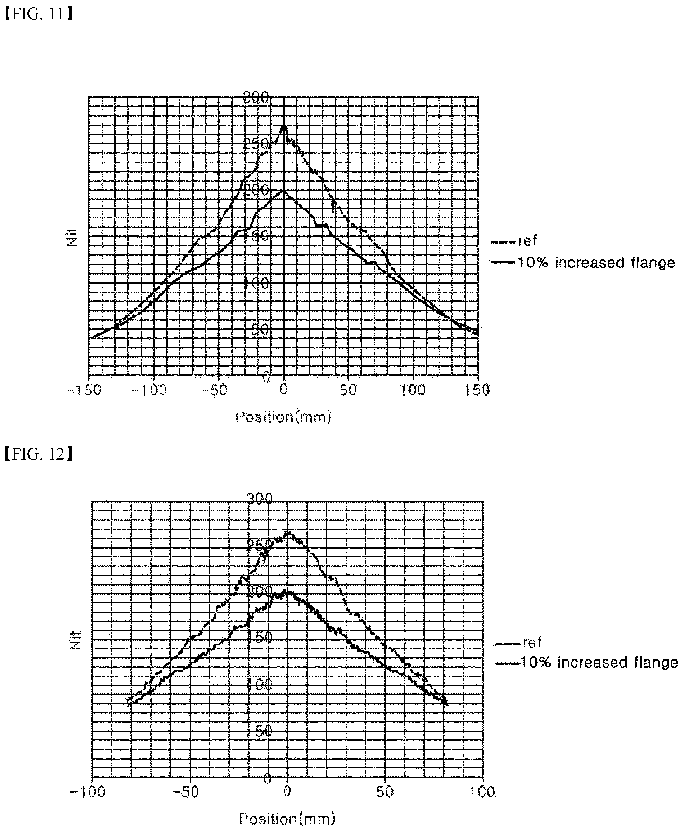

FIG. 11 is a graph comparing a brightness of light emitted from the major axis of the light exiting part in the light emitting module according to the second example and a brightness of light emitted from the major axis of the light exiting part in the light emitting module according to the first example. FIG. 12 is a graph comparing a brightness of light emitted from the minor axis of the light exiting part in the light emitting module according to the second example and a brightness of light emitted from the minor axis of the light exiting part in the light emitting module according to the first example.

A size and a shape of the flange 127 of the lens included in the light emitting module 100 according to the second example is different from those of the flange 127 of the lens included in the light emitting module 100 according to the first example. Accordingly, the brightness of light emitted from the light emitting module 100 can be adjusted according to the size and shape of the flange 127. The reason why the brightness of light emitted from the light emitting module 100 can be adjusted by the size and shape of the flange 127 is that it is possible to reflect the light emitted from the light emitting module 100 at a bottom of the substrate 200 or the backlight unit.

That is, as described with reference to FIG. 6 of the first example, since the lens 120 is larger than the width of the substrate 200, light may be emitted to the outside through the lower surface 125 of the lens 120. Accordingly, if the size and shape of the flange 127 of the lens 120 are changed, an amount of light emitted through the lower surface 125 of the lens 120 may be changed.

As in the second example of the present invention, if the size of the flange 127 is greatly increased more by 10% than in the first embodiment as shown in FIG. 11, it can be seen that the brightness emitted to the major axis direction with respect to the light exiting part of the lens 120 is reduced by about 30% at the center. It can be seen that this is because the amount of light emitted through the lower surface 125 of the lens 120, with the lower surface 125 being exposed to the outside of the substrate 200, is greater than an amount of light reflected from the substrate 200 after being emitted through the lower surface 125 of the lens 120 of the light emitting module 100.

Also, as shown in FIG. 12, it can be seen that a center brightness emitted in the minor axis direction of the light exiting part of the lens 120 is reduced by about 30%.

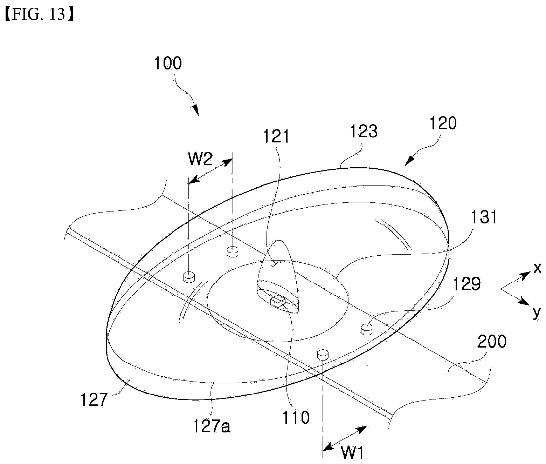

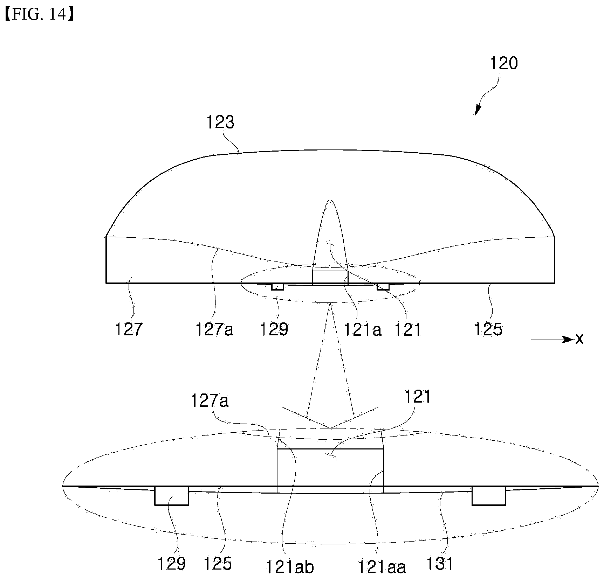

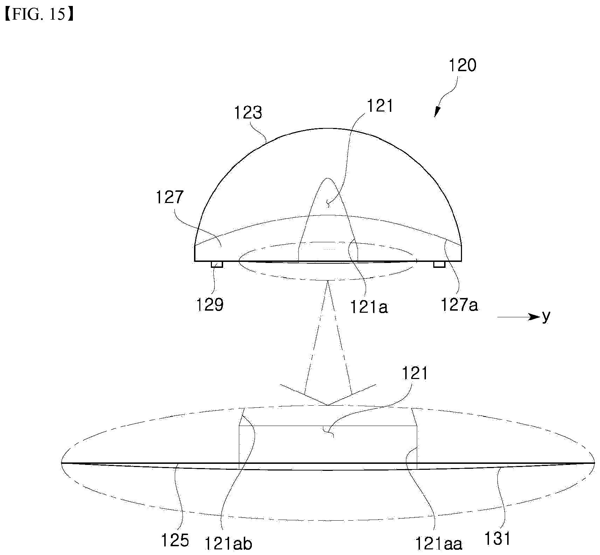

FIG. 13 is a perspective view illustrating a light emitting module according to a third example. FIG. 14 is a cross-sectional view illustrating a major axis of a light exiting part of a lens included in the light emitting module according to the third example. FIG. 15 is a cross-sectional view illustrating a minor axis of the light exiting part of the lens included in the light emitting module according to the third example.

Referring to FIG. 13, a light emitting module 100 according to the third example of the present invention includes a light emitting device and a lens 120.

The light emitting device 110 is disposed on the substrate 200, and the light emitting device 110 in the present example is the same as that in the first example, and a detailed description thereof will be omitted.

The lens 120 is provided to spread light emitted from the light emitting device 110 and is disposed to cover the light emitting device 110. For this purpose, the lens 120 may have a light incident surface 121a on which light emitted from the light emitting device 110 is incident and a light exiting part 123 through which light is emitted to the outside from the lens 120. In this example, the lens 120 includes a light entering part 121 in a concave shape in a lower region thereof, and an inner surface of the light entering part 121 may be the light incident surface 121a.

Here, the light entering part 121 may be formed in the lower region of the lens 120 and may be disposed at a center of the lens 120 as shown in the drawings. A shape of the light entering part 121 is the concave shape like a bell shape as shown in FIGs. 13 to 15. In this example, the light entering part 121 has a concave inner surface as the light incident surface 121a, and the light incident surface 121a includes a light incident vertical surface 121aa and a light incident inclined surface121ab. The light incident vertical surface 121aa is formed at an entrance of the light entering part 121, to be perpendicular to a horizontal surface up to a certain height. The light incident inclined surface121ab is formed to extend from the light incident vertical surface 121aa.

The light incident inclined surface121ab is disposed upward from the light incident vertical surface 121aa and may have a curved surface as a whole. Further, the light incident vertical surface 121aa and a protruding surface 131 of the lens 120 may be extended. The protruding surface 131 of the lens 120 will be described later.

The entrance of the light entering part 121 may have a shape of a figure having a major axis and a minor axis, and it is described that the shape of the entrance of the light entering part 121 is formed in an elliptic shape in this example. As in the first embodiment, the major axis direction of light entering part 121 is defined as a y-axis direction, and the minor axis direction of the light entering part 121 is defined as an x-axis direction.

In this example, a lower surface 125 of the lens 120 may have a planar shape in general. The protruding surface 131 may be formed on the lower surface 125 of the lens 120 around the entrance of the light entering part 121. The protruding surface 131, as shown in the drawing, may be formed in a shape in which a portion of a spherical shape is coupled to the lower surface 125 of the lens 120. That is, the protruding surface 131 is the portion cut from the spherical shape coupled to the lower surface 125 of the lens 120, and accordingly, as shown in FIGs. 14 and 15, it may be formed in the shape protruding from the lower surface 125 of the lens 120.

Here, the light entering part 121 may be disposed at a center of the protruding surface 131 and the light incidence vertical surface 121aa of the light entering part 121 may be connected to the protruding surface 131. Although not shown, the center of the protruding surface 131 and the center of the light entering part 121 may coincide with each other in a plan view of the lens 120.

Moreover, a plurality of legs is disposed on the lower surface 125 of the lens 120, and the plurality of legs may be disposed outside of the protruding surface 131. That is, when the protruding surface 131 is formed on the lower surface 125 of the lens 120, the leg 129 may be disposed ourside of the protruding surface 131 so as not to interfere with the protruding surface 131.

The plurality of legs 129 may be disposed at a longer interval along the major axis of the light entering part 121. That is, in this embodiment, four legs 129 are disposed; Two legs 129 may be disposed at a first interval W1 on one side of the light entering part 121 at the major axis, and remaining two legs 129 may be disposed at a second interval W2 on an opposite side to the one side of the light entering part 121 at the major axis. At this time, the first interval W1 and the second interval W2 may be equal to each other. An interval between the two legs 129 disposed on the one side of the light entering part 121 and the two legs 129 disposed on the other side may be longer than the first and second intervals W1 and W2.

The light exiting part 123 forms an outer shape of the lens 120 and is a surface through which the light incident on the lens 120 is emitted to the outside. A horizontal sectional surface of the light exiting part 123 may have an elliptical shape having a major axis in the x-axis direction and a minor axis in the y-axis direction, and the light exiting part 123 may have a convex shape having a predetermined curvature.

In this example, the major axis of the light exiting part123 and the major axis of the light entering part 121 may be arranged perpendicular to each other.

Accordingly, the light emitted from the light emitting device 110 may be relatively incident more toward the major axis of the light exiting part 123.

Moreover, the lens 120 may further include a flange 127 connecting the light exiting part 123 and the lower surface 120 of the lens 120. The flange 127 may be disposed along the outer periphery of the light exiting part 123 and a longitudinal side surface of the flange 127 may be perpendicular to the lower surface 125 of the lens 120. In this case, a thickness of the flange 127 may vary depending on a location of the light exiting part 123, and the thickness of the flange 127 located at the major axis of the light exiting part 123 may be relatively thicker than the thickness of the flange 127 located at the minor axis of the light exiting part 123. Accordingly, a boundary 127a which is a boundary between the flange 127 and the light exiting part 123 may be formed as a curved line.

In the present example, when a height of the light incident vertical surface 121aa of the light entering part 121 and the thickness of the flange 127 are compared with each other, the height of the light incident vertical surface 121aa of the light entering part 121 may be smaller than the thickness of the flange 127. That is, the height of the light incident vertical surface 121aa may be smaller than the thickness of the flange 127 at the minor axis of the light exiting part 123 which is a part where the thickness of the flange 127 is minimum.

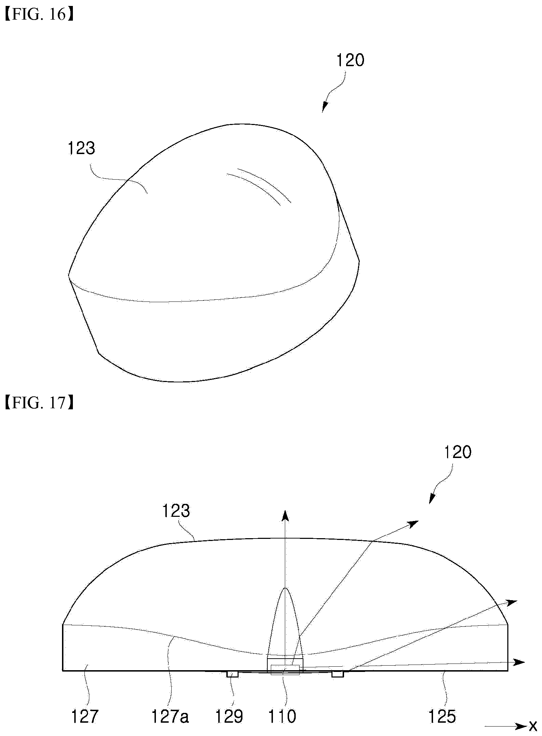

FIG. 16 is a view illustrating the light exiting part of the lens included in the light emitting module according to the third example.

Referring to FIG. 16, the curvature of the light exiting part 123 of the lens 120 included in the light emitting module 100 according to the third example can be described. When designing the lens 120, it is possible to use a function of designing an anamorphic lens which is an optical lens 120 for compressing or converting a wide shot scene to a standard size region on the surface of the lens.

For this purpose, an asymmetric constant (B, asymmetric constant) may be added to design an aspherical lens in the x- and y-axes. That is, a coordinate value of the surface of the light exiting part 123 according to the present example may be expressed as a z value according to Equation 1 depending on x and y values.

[Equation 1]

$$z = \frac{(c_x x^2 + c_y y^2)}{1 + \sqrt{(1 - (1+k_x))c_x^2 x^2 - (1+k_y)c_y^2 y^2}} + \sum_{n=2}^{10} A_{2n}[(1 - B_{2n})x^2 + (1 - B_{2n})y^2]^n$$

An anamorphic surface shape permits a surface having a 20th order aspherical surface shape that is different each other in the Y-Z plane and the X-Z plane, but still has a symmetrical shape in each plane. That is, it is not an actual asymmetric surface form. At this time, the anamorphic surface may be entered with curvature and conic constants and symmetric and asymmetric coefficients with respect to each plane.

Here, the constant A is the symmetry coefficient with respect to the aspherical shape in the Y-Z plane, and the constant B is the asymmetry coefficient, which is different in aspherical surface coefficients between the Y-X plane and the X-Z plane. If the curvature is equal and the conic constant is the same, and the constant B is all zero, Equation 1 can be reduced to a standard rotational symmetric polynomial aspherical surface.

An anamorphic aspherical surface permits a surface having a different 20th order aspheric surface shape in the Y-Z plane and the X-Z plane, but it may still be symmetrical in each plane. X-Y polynomials can be used for a fully asymmetric surface.

This anamorphic aspheric surface may be entered with the curvature and conic constants and the symmetric and asymmetric surface coefficients with respect to each plane.

The constant k is the conical constant, and $k = -(e^2)$. Here, the constant k value is related to a common conical shape as follows. If k = 0, it is a sphere. If -1 <k <0, it is an ellipse having the major axis in the z-axis, if k = -1, it is a parabola, if k <-1, it is a hyperbola, and if k> 0, it is an oblate sphere.

Here, kx is the conic constant in the x-axis, and ky is the conic constant in the y-axis. And cx denotes the curvature in the x-axis, and cy denotes the curvature in the y-axis.

For example, if cx = cy, kx = ky, and all B is zero, Equation 1 reduces to the standard rotational symmetric polynomial aspherical surface.

FIG. 17 is a view illustrating light emitted from the light emitting module according to the third example of the present invention with a side view showing the major axis of the light emitting module.

Referring to FIG. 17, a path of light emitted in the major axis direction will be described. In the present example, the light emitting device 110 emits light both from an upper surface and a side surface of the light emitting device 110. Accordingly, the light emitted from the upper surface of the light emitting device 110 is incident on the lens 120 over the light incident surface 121a of the lens 120 and is emitted through the light exiting part123. Further, the light incident on the light incident inclined surface 121ab of the lens 120 may be refracted and emitted through the light exiting part123. Moreover, the light emitted to the side surface of the light emitting device 110 may be incident on the lens 120 through the light incident vertical surface 121aa and may be directly emitted sidewards through the flange 127 of the lens 120.

In addition, a portion of the light emitted from the side surface of the light emitting device 110 may be reflected upward from the protruding surface 131 coupled to the lower surface 125 of the lens 120 and may be emitted to the outside through the light exiting part 123. Moreover, the light emitted from the light emitting device 110 may be incident on the lens 120 through the light incident surface 121a and may be reflected without being emitted through the light exiting part 123. At this time, a portion of the light reflected from the light exiting part 123 may be re-reflected from the protruding surface 131 and may be emitted again to the outside through the light exiting part 123.

As described above, the light emitted from the light emitting device 110 may be reflected or re-reflected from the protruding surface coupled to the lower surface of the lens and may be emitted through the light exiting part of the lens, thereby increasing the output of the light emitted through the light exiting part of the lens.

Moreover, the portion of the light emitted to the side surface of the light emitting device 110 may be incident on the lens 120 through the light incident vertical surface 121aa and may be directly emitted through the flange 127 of the lens 120. Accordingly, the output of the light emitted from the side surface of the lens 120 may be increased.

The present invention should not be understood as being limited to the examples described above, and the scope of the present invention should be understood as the following claims.

Description of Reference Numerals

| | | | |
|---|---|---|---|
| 100: | light emitting module | | |
| 110: | light emitting device | | |
| 120: | lens | 121: | light entering part |
| 121a: | light incident surface | 121aa: | light incident vertical surface |
| 121ab: | light incident inclined surface | | |
| 123: | light exiting part | 125: | lower surface |
| 127: | flange | 127a: | boundary |
| 129: | leg | 131: | protruding surface |
| 200: | substrate | 300, 400: | backlight unit |
| 310: | backlight module | | |

**Claims**

1.  A backlight module having

    a substrate (200) having an elongated shape in a longitudinal direction and a predetermined length, and
    a plurality of light emitting devices (110) disposed on the substrate (200), and
    a plurality of lenses (120) disposed on the plurality of light emitting devices (110), each lens of the plurality of lenses (120) comprising:

    a light entering part (121) formed in a concave shape in a lower region of the lens (120), and on which light emitted from the light emitting device (110) is incident; and
    a light exiting part (123) through which the light incident through the light entering part (121) is emitted to the outside,
    wherein each of the light entering part (121) and the light exiting part (123) has a shape having a major axis and a minor axis in plan view, and the major axis of the light entering part (121) is orthogonal to the major axis of the light exiting part (123), and
    wherein the light entering part (121) comprises a light incident vertical surface (121aa) extending from the lower surface (125) of the lens (120) and a light incident inclined surface (121ab) extending upward from the light incident vertical surface (121aa),
    wherein each lens (120) of the plurality of lenses is arranged so that the major axis of the light exiting part (121) is perpendicular to the longitudinal direction of the substrate (200).

2.  The backlight module of claim 1, wherein the lower surface (125) of each lens (120) further comprises a protruding surface (131) protruding to have a predetermined curvature to surround the light entering part (121).

3.  The backlight module of claim 2, wherein the light incident vertical surface (121aa) extends from the protruding surface (131).

4.  The backlight module of claim 2, wherein each lens (120) further comprises a plurality of legs (129) coupled to the lower surface (125), and the plurality of legs (129) is disposed outside of the protruding surface (131).

5.  The backlight module of claim 1, wherein each lens (120) further comprises a flange (127) connecting the light exiting part (123) and the lower surface (125).

6.  The backlight module of claim 5, wherein the thickness of the flange (127) is greater at a major axis of the light exiting part (121) than at a minor axis of the light exiting part (121).

7.  The backlight module of claim 6, wherein a shortest distance from the end of the light exiting part (121) of the lens (120) at the major axis of the light exiting part (123) to the end of the flange (127) at the major axis of the flange

(127) is different from a shortest distance from the end of the light exiting part (123) of the lens (120) at the minor axis of the light exiting part (123) to the end of the flange (127) at the minor axis of the flange (127).

8. A display device comprising:
   at least one backlight module (300) as defined in claim 1.

9. The display device of claim 8, wherein the substrate (200) of the at least one backlight module (300) has a width, and the width of the light entering part (121) of each lens (120) in the minor axis direction is smaller than a width of the substrate (200).

10. The display device of claim 8, wherein each lens (120) further comprises four legs (129) arranged at a longer interval along the light entering part (121) in the major axis direction than along the light entering part (121) in the minor axis direction.

11. The display device of claim 8, wherein each lens (120) further comprises a flange (!27) connecting the light exiting part (123) and the lower surface (125).

12. The display device of claim 11, wherein the thickness of the flange (127) is greater at a major axis of the light exiting part (123) than at a minor axis of the light exiting part (123).

13. The display device of claim 11, wherein a shortest distance from the end of the light exiting part (123) of the lens (120) at the major axis of the light exiting part (123) to the end of the flange (127) at the major axis of the flange (127) is different from a shortest distance from the end of the light exiting part (123) of the lens (120) at the minor axis of the light exiting part (123) to the end of the flange (127) at the minor axis of the flange (127).


**Patentansprüche**

1. Hintergrundbeleuchtungsmodul, das aufweist

   ein Substrat (200) mit einer länglichen Form in einer Längsrichtung und einer vorbestimmten Länge, und
   eine Vielzahl von lichtemittierenden Vorrichtungen (110), die auf dem Substrat (200) angeordnet sind, und
   eine Vielzahl von Linsen (120), die auf der Vielzahl von lichtemittierenden Vorrichtungen (110) angeordnet sind,
   wobei jede Linse der Vielzahl von Linsen (120) umfasst:

   einen Lichteintrittsteil (121), der in einer konkaven Form in einem unteren Bereich der Linse (120) ausgebildet ist und auf den von der lichtemittierenden Vorrichtung (110) emittiertes Licht einfällt; und
   einen Lichtaustrittsteil (123), durch den das durch den Lichteintrittsteil (121) einfallende Licht nach außen abgestrahlt wird,
   wobei sowohl der Lichteintrittsteil (121) als auch der Lichtaustrittsteil (123) in der Draufsicht eine Form mit einer Hauptachse und einer Nebenachse haben, und die Hauptachse des Lichteintrittsteils (121) orthogonal zur Hauptachse des Lichtaustrittsteils (123) ist, und
   wobei der Lichteintrittsteil (121) eine vertikale Lichteinfallsfläche (121aa), die sich von der unteren Fläche (125) der Linse (120) erstreckt, und eine geneigte Lichteinfallsfläche (121ab), die sich von der vertikalen Lichteinfallsfläche (121aa) nach oben erstreckt, aufweist,
   wobei jede Linse (120) der Vielzahl von Linsen so angeordnet ist, dass die Hauptachse des Lichtaustrittsteils (121) senkrecht zur Längsrichtung des Substrats (200) verläuft.

2. Hintergrundbeleuchtungsmodul nach Anspruch 1, wobei die untere Fläche (125) jeder Linse (120) ferner eine vorstehende Fläche (131) umfasst, die so vorsteht, dass sie eine vorbestimmte Krümmung aufweist, um den Lichteintrittsteil (121) zu umgeben.

3. Hintergrundbeleuchtungsmodul nach Anspruch 2, wobei sich die vertikale Lichteinfallsfläche (121aa) von der vorstehenden Fläche (131) aus erstreckt.

4. Hintergrundbeleuchtungsmodul nach Anspruch 2, wobei jede Linse (120) ferner eine Vielzahl von Schenkeln (129) umfasst, die mit der unteren Fläche (125) verbunden sind, und die Vielzahl von Schenkeln (129) außerhalb der vorstehenden Fläche (131) angeordnet ist.

**5.** Hintergrundbeleuchtungsmodul nach Anspruch 1, wobei jede Linse (120) ferner einen Flansch (127) umfasst, der den Lichtaustrittsteil (123) und die untere Fläche (125) verbindet.

**6.** Hintergrundbeleuchtungsmodul nach Anspruch 5, wobei die Dicke des Flansches (127) an einer Hauptachse des Lichtaustrittsteils (121) größer ist als an einer Nebenachse des Lichtaustrittsteils (121).

**7.** Hintergrundbeleuchtungsmodul nach Anspruch 6, wobei der kürzeste Abstand vom Ende des Lichtaustrittsteils (121) der Linse (120) an der Hauptachse des Lichtaustrittsteils (123) bis zum Ende des Flansches (127) an der Hauptachse des Flansches (127) von dem kürzesten Abstand vom Ende des Lichtaustrittsteils (123) der Linse (120) an der Nebenachse des Lichtaustrittsteils (123) bis zum Ende des Flansches (127) an der Nebenachse des Flansches (127) verschieden ist.

**8.** Anzeigevorrichtung, die umfasst:
mindestens ein Hintergrundbeleuchtungsmodul (300) nach Anspruch 1.

**9.** Anzeigevorrichtung nach Anspruch 8, wobei das Substrat (200) des mindestens einen Hintergrundbeleuchtungsmoduls (300) eine Breite aufweist und die Breite des Lichteintrittsteils (121) jeder Linse (120) in der Nebenachsenrichtung kleiner ist als eine Breite des Substrats (200).

**10.** Anzeigevorrichtung nach Anspruch 8, wobei jede Linse (120) ferner vier Schenkel (129) umfasst, die in einem größeren Abstand entlang des Lichteintrittsteils (121) in der Hauptachsenrichtung als entlang des Lichteintrittsteils (121) in der Nebenachsenrichtung angeordnet sind.

**11.** Anzeigevorrichtung nach Anspruch 8, wobei jede Linse (120) ferner einen Flansch (127) aufweist, der den Lichtaustrittsteil (123) und die untere Fläche (125) verbindet.

**12.** Anzeigevorrichtung nach Anspruch 11, wobei die Dicke des Flansches (127) an einer Hauptachse des Lichtaustrittsteils (123) größer ist als an einer Nebenachse des Lichtaustrittsteils (123).

**13.** Anzeigevorrichtung nach Anspruch 11, wobei der kürzeste Abstand vom Ende des Lichtaustrittsteils (123) der Linse (120) an der Hauptachse des Lichtaustrittsteils (123) bis zum Ende des Flansches (127) an der Hauptachse des Flansches (127) von dem kürzesten Abstand vom Ende des Lichtaustrittsteils (123) der Linse (120) an der Nebenachse des Lichtaustrittsteils (123) bis zum Ende des Flansches (127) an der Nebenachse des Flansches (127) verschieden ist.

**Revendications**

**1.** Module de rétroéclairage ayant

un substrat (200) ayant une forme allongée dans une direction longitudinale et une longueur prédéterminée, et
une pluralité de dispositifs électroluminescents (110) disposés sur le substrat (200), et
une pluralité de lentilles (120) disposées sur la pluralité de dispositifs électroluminescents (110), chaque lentille de la pluralité de lentilles (120) comprenant :

une partie d'entrée de lumière (121) de forme concave dans une région inférieure de la lentille (120), et sur laquelle la lumière émise par le dispositif électroluminescent (110) est incidente ; et
une partie de sortie de lumière (123) à travers laquelle la lumière incidente à travers la partie d'entrée de lumière (121) est émise vers l'extérieur,
dans lequel la partie d'entrée de lumière (121) et la partie de sortie de lumière (123) ont chacune une forme ayant un axe majeur et un axe mineur en vue en plan, et l'axe majeur de la partie d'entrée de lumière (121) est orthogonal à l'axe majeur de la partie de sortie de lumière (123), et
la partie d'entrée de lumière (121) comprend une surface verticale d'incidence de lumière (121aa) s'étendant à partir de la surface inférieure (125) de la lentille et une surface inclinée d'incidence de lumière (121ab) s'étendant vers le haut à partir de la surface verticale d'incidence de lumière (121aa),
dans lequel chaque lentille (120) de la pluralité de lentilles est agencée de manière à ce que l'axe majeur de la partie de sortie de lumière (121) soit perpendiculaire à la direction longitudinale du substrat (200) .

**2.** Module de rétroéclairage selon la revendication 1, dans lequel la surface inférieure (125) de chaque lentille (120) comprend en outre une surface saillante (131) faisant saillie pour avoir une courbure prédéterminée afin d'entourer la partie d'entrée de lumière (121).

**3.** Module de rétroéclairage selon la revendication 2, dans lequel la surface verticale d'incidence de lumière (121aa) s'étend à partir de la surface saillante (131).

**4.** Module de rétroéclairage selon la revendication 2, dans lequel chaque lentille comprend en outre une pluralité de pattes (129) couplées à la surface inférieure (125), et la pluralité de pattes (129) est disposée à l'extérieur de la surface saillante (131).

**5.** Module de rétroéclairage selon la revendication 1, dans lequel chaque lentille comprend en outre une bride (127) reliant la partie de sortie de lumière (123) et la surface inférieure (125).

**6.** Module de rétroéclairage selon la revendication 5, dans lequel l'épaisseur de la bride (127) est plus grande au niveau d'un axe majeur de la partie de sortie de lumière (121) qu'au niveau d'un axe mineur de la partie de sortie de lumière (121).

**7.** Module de rétroéclairage selon la revendication 6, dans lequel une distance la plus courte à partir de l'extrémité de la partie de sortie de lumière (121) de la lentille (120) au niveau de l'axe majeur de la partie de sortie de lumière (123) jusqu'à l'extrémité de la bride (127) au niveau de l'axe majeur de la bride (127) est différente d'une distance la plus courte à partir de l'extrémité de la partie de sortie de lumière (123) de la lentille (120) au niveau de l'axe mineur de la partie de sortie de lumière (123) jusqu'à l'extrémité de la bride (127) au niveau de l'axe mineur de la bride (127).

**8.** Dispositif d'affichage comprenant :
au moins un module de rétroéclairage (300) tel que défini dans la revendication 1.

**9.** Dispositif d'affichage selon la revendication 8, dans lequel le substrat (200) de l'au moins un module de rétroéclairage (300) a une largeur, et la largeur de la partie d'entrée de lumière (121) de chaque lentille (120) dans la direction de l'axe mineur est inférieure à une largeur du substrat (200).

**10.** Dispositif d'affichage selon la revendication 8, dans lequel chaque lentille (120) comprend en outre quatre pattes (129) agencées à un intervalle plus long le long de la partie d'entrée de lumière (121) dans la direction de l'axe majeur que le long de la partie d'entrée de lumière (121) dans la direction de l'axe mineur.

**11.** Le dispositif d'affichage selon la revendication 8, dans lequel chaque lentille (120) comprend en outre une bride (127) reliant la partie de sortie de lumière (123) et la surface inférieure (125).

**12.** Dispositif d'affichage selon la revendication 11, dans lequel l'épaisseur de la bride (127) est plus grande au niveau d'un axe majeur de la partie de sortie de lumière (123) qu'au niveau d'un axe mineur de la partie de sortie de lumière (123).

**13.** Dispositif d'affichage selon la revendication 11, dans lequel une distance la plus courte à partir de l'extrémité de la partie de sortie de lumière (123) de la lentille (120) au niveau de l'axe majeur de la partie de sortie de lumière (123) jusqu'à l'extrémité de la bride (127) au niveau de l'axe majeur de la bride (127) est différente d'une distance la plus courte à partir de l'extrémité de la partie de sortie de lumière (123) de la lentille (120) au niveau de l'axe mineur de la partie de sortie de lumière (123) jusqu'à l'extrémité de la bride (127) au niveau de l'axe mineur de la bride (127).

【FIG. 1】

【FIG. 2】

【FIG. 3】

120

123

t2

129 127 121 121a 127a

→ y

【FIG. 4】

120

123 121 121a

127 127a

110 125

→ x

【FIG. 5】

123    120

G

129  127  121  110  121a  127a    → y

【FIG. 6】

100

121

200

【FIG. 7】

【FIG. 8】

【FIG. 9】

120

123

127  127a  121  121a  129  125  →x

【FIG. 10】

120

127

123

121

【FIG. 11】

Position(mm)

【FIG. 12】

Position(mm)

【FIG. 13】

【FIG. 14】

【FIG. 15】

【FIG. 16】

【FIG. 17】

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 101690740 B1

- US 2016201875 A1